# EUROPEAN PATENT APPLICATION

(11) **EP 3 934 092 A1**
(43) Date of publication of application: **05.01.2022**
(21) Application number: 20762707.6
(22) Date of filing: 19.02.2020
(51) Int. Cl.: H02N 1/08, H01L 41/113, H01L 41/193, H02J 7/00

(54) **DIELECTRIC ELASTOMER POWER GENERATION SYSTEM**

(30) Priority: 28.02.2019 JP 2019035453
(71) Applicant: Zeon Corporation, Tokyo 100-8246 (JP); Waki, Mikio, Sakura-shi, Tochigi 329-1334 (JP)
(72) Inventor: UEJIMA, Mitsugu, Tokyo 100-8246 (JP); TAKESHITA, Makoto, Tokyo 100-8246 (JP); CHIBA, Seiki, Tokyo 152-0023 (JP); WAKI, Mikio, Sakura-shi, Tochigi 329-1334 (JP)
(74) Representative: Schäflein, Christian Georg
(86) International application number: PCT/JP2020/006401
(87) International publication number: WO 2020/175257

(57) **Abstract**

A dielectric elastomer power generation system of the invention includes: a power generation unit including a dielectric elastomer power generation element having a dielectric elastomer layer flanked by two electrode layers; a step-down unit including capacitors; a power storage unit for input of an output power from the step-down unit; and a control unit that controls the connection between the step-down unit and the power generation unit or power storage unit. The step-down unit includes first diodes and second diodes, where the first diodes form a circuit that connects the capacitors in series when the power generation unit is connected to the step-down unit, and the second diodes form a circuit that connects the capacitors in parallel when the step-down unit is connected to the power storage unit. This configuration serves to store the generated power more efficiently in the power storage unit, e.g., a secondary battery.

## Description

### TECHNICAL FIELD

The present invention relates to a dielectric elastomer power generation system.

### BACKGROUND ART

A dielectric elastomer element including a dielectric elastomer layer and a pair of electrode layers flanking the dielectric elastomer layer has been developed for actuation and power generation purposes. Patent documents 1 and 2 disclose a dielectric elastomer power generation system in which a dielectric elastomer element is used for power generation. The dielectric elastomer power generation system generates power by converting external force (mechanical energy) that acts to stretch the dielectric elastomer element into electric energy. The power thus generated is stored in a secondary battery, such as a nickel hydride battery or a lithium-ion battery.

In using the dielectric elastomer element, power can be generated by each cycle consisting of stretch and contraction of the dielectric elastomer element. The advantage is that even if the external force causing this cycle changes in a relatively short period of time, the dielectric elastomer element can be stretched and contracted rapidly, thereby following the change. Also, power generated by the dielectric elastomer element has a relatively high voltage, several thousand volts, for example. On the other hand, the secondary battery utilizes a chemical reaction to store power, which requires a relatively long time for charging. Furthermore, the voltage appropriate for charging the secondary battery is much lower than the voltage of the power generated by the dielectric elastomer element. Accordingly, it is difficult to efficiently store the power generated by the dielectric elastomer element in the secondary battery.

### PRIOR ART DOCUMENT

### Patent Document

Patent Document 1: JP-B-5479659
Patent Document 2: JP-B-5509350

### SUMMARY OF THE INVENTION

### Problem to be Solved by the Invention

The present disclosure has been conceived under the above circumstances, and aims to provide a dielectric elastomer power generation system capable of storing power more efficiently.

### Means to Solve the Problem

A dielectric elastomer power generation system provided by the present disclosure includes: a power generation unit including a dielectric elastomer power generation element having a dielectric elastomer layer and a pair of electrode layers flanking the dielectric elastomer layer; a step-down unit including a plurality of capacitors; a power storage unit to which an output power from the step-down unit is inputted; and a control unit that controls a connection between the step-down unit and each of the power generation unit and the power storage unit. The step-down unit includes a plurality of first diodes and a plurality of second diodes, where the first diodes form a circuit that connects the plurality of capacitors in series when the power generation unit is connected to the step-down unit, while the second diodes form a circuit that connects the plurality of capacitors in parallel when the step-down unit is connected to the power storage unit.

### Advantages of the Invention

According to the dielectric elastomer power generation system of the present disclosure, generated power can be stored more efficiently in the power storage unit such as a secondary battery.

Other features and advantages of the present disclosure will be more apparent from detailed description given below with reference to the accompanying drawings.

### BRIEF DESCRIPTION OF THE DRAWINGS

Fig. 1 schematically shows the system configuration of a dielectric elastomer power generation system A1.
Fig. 2 schematically shows the principle of power generation by a dielectric elastomer power generation element of the dielectric elastomer power generation system in Fig. 1.
Fig. 3 schematically shows the principle of power generation by the dielectric elastomer power generation element of the dielectric elastomer power generation system in Fig. 1.
Fig. 4 is a circuit diagram showing a step-down unit of the dielectric elastomer power generation system in Fig. 1.
Fig. 5 is a system configuration diagram that schematically shows power generation by the dielectric elastomer power generation system in Fig. 1.
Fig. 6 is a system configuration diagram that schematically shows power generation by the dielectric elastomer power generation system in Fig. 1.

### MODE FOR CARRYING OUT THE INVENTION

Preferred embodiments of the present disclosure are described below with reference to the drawings.

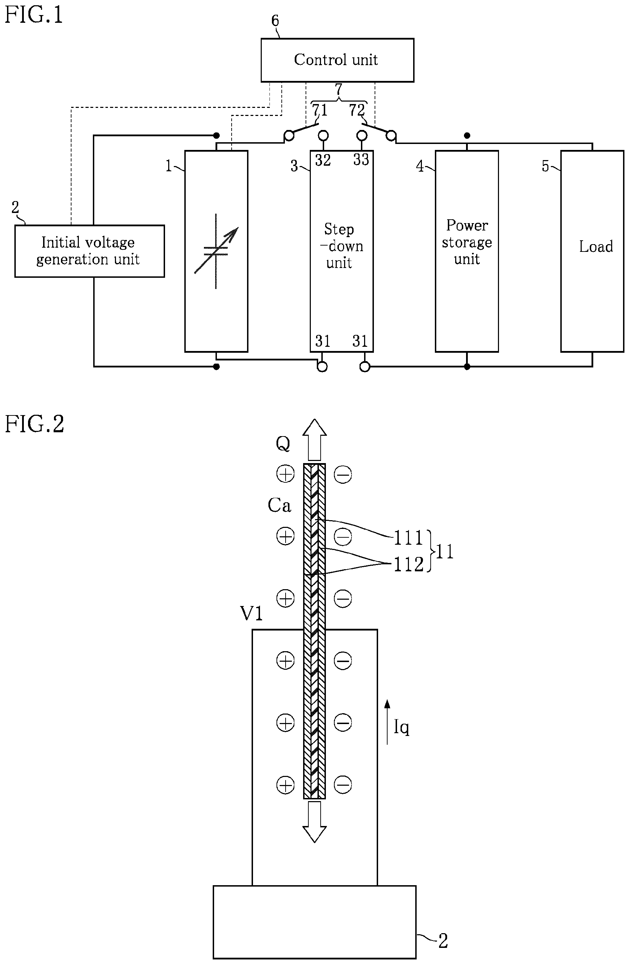

Figs. 1 to 6 show the dielectric elastomer power generation system A1. The dielectric elastomer power generation system A1 according to the present embodiment includes a power generation unit 1, a control unit 6, a step-down unit 3, a power storage unit 4, a load 5, and a switching unit 7. The dielectric elastomer power generation system A1 generates power by utilizing external force. The specific configuration of the source of external force is not particularly limited. For example, the source of natural energy such as the energy of ocean waves or the source of biological energy such as the energy of human body can be used as appropriate.

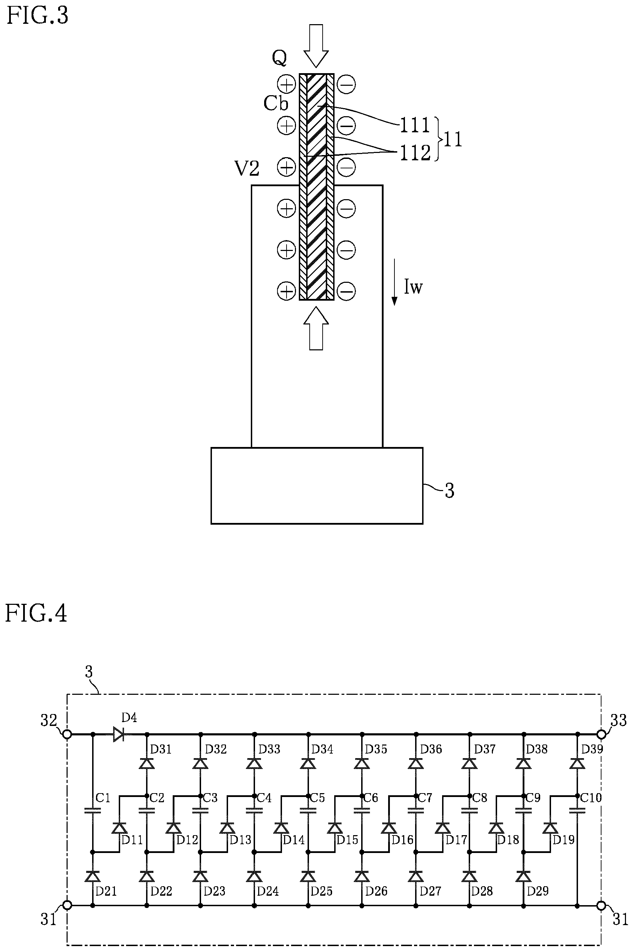

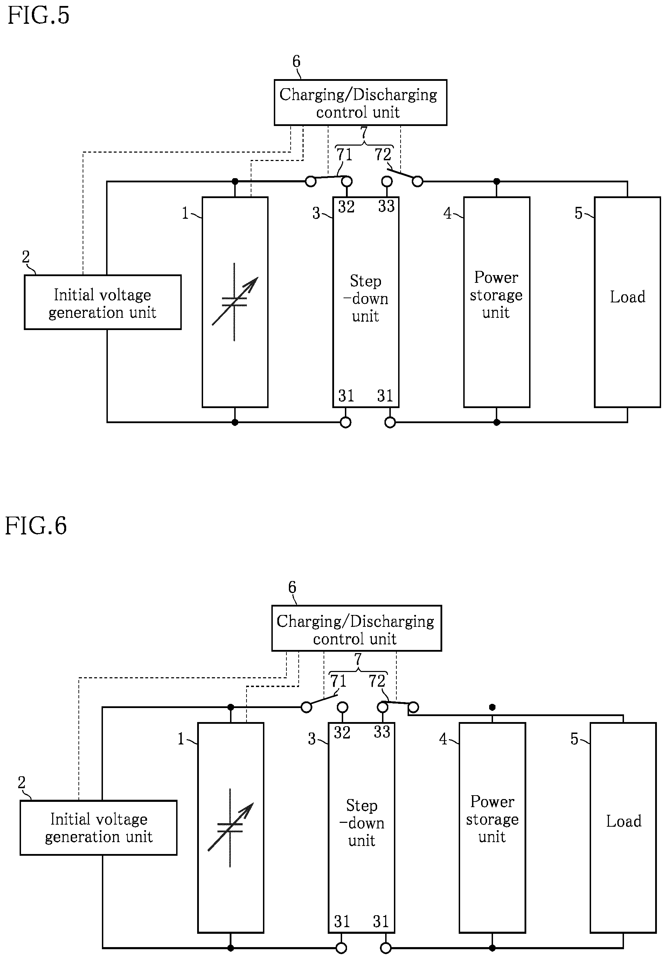

Fig. 1 schematically shows the system configuration of the dielectric elastomer power generation system A1. Fig. 2 schematically shows the principle of power generation by the power generation unit 1 of the dielectric elastomer power generation system A1. Fig. 3 schematically shows the principle of power generation by the power generation unit 1 of the dielectric elastomer power generation system A1. Fig. 4 is a circuit diagram showing the step-down unit 3 of the dielectric elastomer power generation system A1. Fig. 5 is a system configuration diagram that schematically shows power generation by the dielectric elastomer power generation system A1. Fig. 6 is a system configuration diagram that schematically shows power generation by the dielectric elastomer power generation system A1.

The power generation unit 1 converts mechanical energy into electric energy in the dielectric elastomer power generation system A1. The power generation unit 1 includes a dielectric elastomer power generation element 11. Note that the dielectric elastomer power generation element 11 is schematically shown in Figs. 1 to 3. The dielectric elastomer power generation element 11 includes a dielectric elastomer layer 111 and a pair of electrode layers 112. If necessary, the power generation unit 1 may further include, in addition to the dielectric elastomer power generation element 11, a structural member (not illustrated) for transmitting inputted external force to the dielectric elastomer power generation element 11, or a tension maintenance mechanism (not illustrated) for generating tension in the dielectric elastomer power generation element 11 so as to utilize the tension to realize a power generating operation.

The dielectric elastomer layer 111 contains one or more types of elastomers (polymeric compounds having rubber-like elasticity). The elastomers are not limited to any particular types, but may be thermosetting elastomers or thermoplastic elastomers.

The thermosetting elastomers are not limited to any particular types, but may be natural rubbers, synthetic rubbers, silicone rubber elastomers, urethane rubber elastomers, and fluoro-rubber elastomers, for example.

The thermoplastic elastomers may be copolymers of aromatic vinyl-based monomers and conjugated diene-based monomers. Specifically, the copolymers of aromatic vinyl-based monomers and conjugated diene-based monomers may be: diblock copolymers such as styrene-butadiene block copolymers or styrene-isoprene block copolymers; triblock copolymers such as styrene-butadiene-styrene block copolymers, styrene-isoprene-styrene block copolymers (SIS), styrene-butadiene-isoprene block copolymers or styrene-isobutylene-styrene block copolymers (SIBS); styrene-containing multiblock copolymers such as styrene-butadiene-styrene-butadiene block copolymers, styrene-isoprene-styrene-isoprene block copolymers, styrene-butadiene-isoprene-styrene block copolymers, styrene-butadiene-styrene-isoprene block copolymers, or styrene-isobutylene-butadiene-styrene block copolymers; and hydrogenated or partially hydrogenated products of these. Among these copolymers, block copolymers such as SIS are more preferably used.

In addition to the elastomers listed above, the dielectric elastomer layer 111 may contain one or more types of other materials, such as additives.

The pair of electrode layers 112 flank the dielectric elastomer layer 111, and receive an initial charge to generate an output voltage. The electrode layers 112 are made of an electrically conductive material that is elastically deformable to comply with elastic deformation of the dielectric elastomer layer 111. Examples of such a material include an elastically deformable material containing fillers to impart electrical conductivity to the material. Preferably, the fillers contain one or more types of conductive materials such as carbon materials, conductive polymeric compounds, and metallic materials. Examples of carbon materials include graphite, fullerene, carbon nanotubes (CNTs), and graphene. The carbon materials may be subjected to one or more processes, including metal doping, metal-encapsulation, and metal plating. Examples of the conductive polymeric compounds include polyacethylene, polythiophene, polypyrrole, polyphenylene, polyphenylene vinylene, and polybenzothiazole. Examples of the metallic materials include silver (Ag), gold (Au), and aluminum (Al), as well as alloys of such metals.

When no external force or constraint is applied to the dielectric elastomer power generation element 11 and no voltage is applied to the pair of electrode layers 112, the dielectric elastomer power generation element 11 is in a relaxed state having a natural length with no voluntary stretch or contraction. When an external force is applied, the dielectric elastomer layer 111 deforms elastically.

An initial voltage generation unit 2 is a power supply circuit, for example, and applies an initial voltage to the pair of electrode layers 112 of the dielectric elastomer power generation element 11. The initial voltage generation unit 2 may have a switching function for appropriately turning on and off the electrical connection with the power generation unit 1.

The step-down unit 3 temporarily stores power generated by the power generation unit 1, and steps down the power to output the power. As shown in Fig. 4, the step-down unit 3 includes a plurality of capacitors C, a plurality of diodes D, a first terminal 31, a second terminal 32, and a third terminal 33. In the illustrated example, two first terminals 31 are provided for convenience.

The number of capacitors C and the number of diodes D are not particularly limited. In the illustrated example, the plurality of capacitors C include capacitors C1 to C10, and the plurality of diodes D include diodes D11 to D19, D21 to D29, D31 to D39, and D4.

Assuming that use is made of wires allowing bidirectional conduction instead of the diodes D, the capacitors C1 to C10 are connected in parallel between the wire connecting the two first terminals 31 and the wire connecting the second terminal 32 and the third terminal 33. The diodes D11 to D19 are each connected between adjacent capacitors C, allowing a current to flow from the first terminals 31 to the second terminal 32 and the third terminal 33. The diodes D21 to D29 are connected to allow a current to flow from the first terminals 31 to the diodes D11 to D19. The diodes D31 to D39 are connected to allow a current to flow from the capacitors C2 to C10 to the second terminal 32 and the third terminal 33. The diode D4 is connected between the second terminal 32 and the diode D31 to allow a current to flow from the second terminal 32 to the third terminal 33.

The capacitors C1 to C10 are intended to be connected in series or in parallel with each other by the switching unit 7 described below. The capacitors C are not limited to any specific type, and may be film capacitors, ceramic capacitors, or electrolytic capacitors, for example.

The control unit 6 controls application of an initial voltage from the initial voltage generation unit 2 to the power generation unit 1, and also controls input of the output power from the power generation unit 1 to the step-down unit 3 and the power storage unit 4. The control unit 6 further controls switching of the switching unit 7 when applying the initial voltage and when inputting the output power. For example, the control unit 6 includes a CPU that controls the initial voltage generation unit 2 and the switching unit 7, and also includes a detector that monitors the status of each of the power generation unit 1, the initial voltage generation unit 2, the step-down unit 3, the power storage unit 4, and the load 5.

The power storage unit 4 is the last power storage unit in the dielectric elastomer power generation system A1 and receives the power temporarily stored and stepped down in the step-down unit 3. The power storage unit 4 is not particularly limited in configuration as long as it has a storage capacity capable of appropriately storing the power generated by the power generation unit 1. The power storage unit 4 may be a secondary battery such as a nickel hydride battery or a lithium-ion battery.

The load 5 consumes the power generated by the power generation unit 1. The load 5 is not particularly limited as long as it receives power and performs a desired function.

The switching unit 7 switches on and off the connection between the step-down unit 3 and each of the power generation unit 1 and the power storage unit 4. The switching unit 7 is not particularly limited in configuration. For example, the switching unit 7 may be a wiring circuit including a required number of switching components, or may be an electronic module such as a switching element. In Fig. 1, the switching unit 7 is schematically shown for convenience of explaining its function. In the present embodiment, the switching unit 7 includes a first switch 71 and a second switch 72. The first switch 71 connects the power generation unit 1 and the second terminal 32 of the step-down unit 3. The second switch 72 connects the third terminal 33 of the step-down unit 3 and the power storage unit 4. Although the two first terminals 31 are in continuous connection with the power generation unit 1 and the power storage unit 4 in the illustrated example, the present disclosure is not limited to this. The first switch 71 may further turn on and off one of the first terminals 31, and the second switch 72 may further turn on and off the other one of the first terminals 31. The control unit 6 and the switching unit 7 may be integrated into a unitary component.

The first switch 71 disconnects or connects the power generation unit 1 and the second terminal 32 of the step-down unit 3 according to an instruction from the control unit 6. The second switch 72 disconnects or connects the third terminal 33 of the step-down unit 3 and the power storage unit 4 according to an instruction from the control unit 6.

Figs. 2 and 3 show the principle of power generation in the dielectric elastomer power generation element 11. In Fig. 2, the dielectric elastomer power generation element 11 is connected to the initial voltage generation unit 2. As shown in Fig. 2, the dielectric elastomer power generation element 11 is subjected to an external force acting along the vertical direction. This causes the dielectric elastomer layer 111 of the dielectric elastomer power generation element 11 to be stretched in the vertical direction. As a result, the area of the dielectric elastomer layer 111 is increased, and the thickness thereof is reduced. The area of each of the pair of electrode layers 112 is increased following the dielectric elastomer layer 111. In this state, when the dielectric elastomer power generation element 11 is regarded as a capacitor, its capacitance Ca is larger than the capacitance before an external force is applied. The dielectric elastomer power generation element 11 in this state is subjected to an initial voltage. Specifically, the initial voltage generation unit 2 applies a voltage V1 to the dielectric elastomer power generation element 11 having the capacitance Ca according to an instruction from the control unit 6, so that a current Iq flows and a charge Q is provided.

Fig. 3 shows the dielectric elastomer power generation element 11 placed in a contracted state from the state shown in Fig. 2, as a result of the external force being weakened or becoming zero after the state shown in Fig. 2. In Fig. 3, the power generation unit 1 is connected to the step-down unit 3. In this state, the area of the dielectric elastomer layer 111 is reduced, and the thickness thereof is increased. The area of each of the pair of electrode layers 112 is reduced following the dielectric elastomer layer 111. In this state, when the dielectric elastomer power generation element 11 is regarded as a capacitor, its capacitance Cb is smaller than the capacitance Ca. However, the charge Q stored in the pair of electrode layers 112 is constant. Accordingly, the ratio of voltage V2 to the voltage V1 is inversely proportional to the ratio of capacitance Cb to the capacitance Ca, and the voltage V2 is higher than the voltage V1. Accordingly, the step-down unit 3 receives an output current Iw from the pair of electrode layers 112 at the voltage V2 higher than the voltage V1, under the control described below. As such, an output power higher than the power required to apply the initial voltage is obtained. This is the power generation in the dielectric elastomer power generation element 11.

Next, the operation of generating and storing power in the dielectric elastomer power generation system A1 will be described with reference to Figs. 4 to 6.

Fig. 5 shows the state where the dielectric elastomer power generation element 11 in the power generation unit 1 of the dielectric elastomer power generation system A1 is stretched by an external force and then contracted as a result of the external force being weakened or becoming zero. In this state, the first switch 71 of the switching unit 7 is in a closed state, and the second switch 72 is in an open state by an instruction from the control unit 6. In other words, the step-down unit 3 is connected to the power generation unit 1, and disconnected from the power storage unit 4. When the dielectric elastomer power generation element 11 of the power generation unit 1 is stretched and contracted in the state described above, power is generated in the dielectric elastomer power generation element 11 by the principle described with reference to Figs. 2 and 3.

In this case, as shown in Fig. 4, a circuit is formed in the step-down unit 3 where the capacitors C1 to C10 are connected in series, via the capacitor C1, the diode D11, the capacitor C2, the diode D12, the capacitor C3, the diode D13, the capacitor C4, the diode D14, the capacitor C5, the diode D15, the capacitor C6, the diode D16, the capacitor C7, the diode D17, the capacitor C8, the diode D18, the capacitor C9, the diode D19, and the capacitor C10 from the second terminal 32 to the first terminals 31. As a result, when power is stored, the voltage V2 shown in Fig. 3 is divided in the capacitors C1 to C10. When the capacitors C1 to C10 are equal in capacitance, power is stored in each of the capacitors C1 to C10 at 1/10 of the voltage V2. Furthermore, the amount of charge stored in each of the capacitors C1 to C10 is equal. Note that the diodes D11 to D19 correspond to the first diodes of the present disclosure.

Next, as shown in Fig. 6, the first switch 71 of the switching unit 7 is in an open state, and the second switch 72 is in a closed state by an instruction from the control unit 6. In other words, the step-down unit 3 is connected to the power storage unit 4 or the load 5 and disconnected from the power generation unit 1. In this case, as shown in Fig. 4, a circuit is formed in the step-down unit 3 where the capacitors C1 to C10 are connected in parallel between the first terminals 31 and the third terminal 33, and the diodes D21 to D29, the diodes D31 to D39, and the diode D4 allow energization from the first terminals 31 to the third terminal 33. As a result, the voltage of the capacitors C1 to C10 connected in parallel is applied across the first terminals 31 and the third terminal 33. When the capacitors C1 to C10 are equal in capacitance, the volage applied across the first terminals 31 and the third terminal 33 is 1/10 of the voltage V2. Accordingly, power is stored in the power storage unit 4 at a voltage of 1/10 of the voltage V2. Note that the diodes D21 to D29, the diodes D31 to D39, and D4 correspond to the second diodes of the present disclosure.

The state shown in Fig. 5 and the state shown in Fig. 6 are repeated by the control unit 6 controlling the switching unit 7 according to the stretch and contraction operation of the power generation unit 1, whereby power is generated in the dielectric elastomer power generation system A1. The stretch and contraction operation of the power generation unit 1 may be detected by the detector in the control unit 6, for example. In this case, the detector may detect the stretch and contraction of the dielectric elastomer power generation element 11, or may detect variations in voltage between the pair of electrode layers 112.

The following describes advantages of the dielectric elastomer power generation system A1.

According to the present embodiment, the power generated by the power generation unit 1 is first stored by the step-down unit 3 and then outputted to the power storage unit 4. Since the power storage by the step-down unit 3 with the plurality of capacitors C does not involve any chemical reactions, the power generated by the power generation unit 1 can be promptly stored. Furthermore, when the power from the power generation unit 1 is inputted to the step-down unit 3, the voltage is divided and stored in the plurality of capacitors C. As a result, the voltage at each capacitor C is lower than the voltage V2 that is the output voltage of the power generation unit 1. This makes it possible to output power from the step-down unit 3 to the power storage unit 4 or the load 5 at a voltage lower than the voltage V2. This is advantageous for the power storage unit 4 to store power at an appropriate voltage. Thus, according to the dielectric elastomer power generation system A1, the power generated by the power generation unit 1 can be stored in the power storage unit 4 more efficiently.

The dielectric elastomer power generation system according to the present disclosure is not limited to the above embodiment. Various design changes can be made to the specific configurations of the elements of the dielectric elastomer power generation system according to the present disclosure.

## Claims

1. A dielectric elastomer power generation system comprising:
a power generation unit including a dielectric elastomer power generation element having a dielectric elastomer layer and a pair of electrode layers flanking the dielectric elastomer layer;
a step-down unit including a plurality of capacitors;
a power storage unit to which an output power from the step-down unit is inputted; and
a control unit that controls a connection between the step-down unit and each of the power generation unit and the power storage unit,
wherein the step-down unit includes: a plurality of first diodes forming a circuit that connects the plurality of capacitors in series when the power generation unit is connected to the step-down unit; and a plurality of second diodes forming a circuit that connects the plurality of capacitors in parallel when the step-down unit is connected to the power storage unit.

2. The dielectric elastomer power generation system according to claim 1, further comprising a switching unit that switches a connection between the step-down unit and each of the power generation unit and the power storage unit.
